(19) Europäisches Patentamt
European Patent Office
Office européen des brevets

(11) Veröffentlichungsnummer: **0 126 029**
**B1**

(12) # EUROPÄISCHE PATENTSCHRIFT

(45) Veröffentlichungstag der Patentschrift: **26.08.87**

(51) Int. Cl.⁴: **G 03 C 1/68**

(21) Anmeldenummer: **84810216.6**

(22) Anmeldetag: **07.05.84**

(54) **Verfahren zur Bilderzeugung.**

(30) Priorität: **11.05.83 GB 8312879**
**15.07.83 GB 8319218**

(43) Veröffentlichungstag der Anmeldung:
**21.11.84 Patentblatt 84/47**

(45) Bekanntmachung des Hinweises auf die Patenterteilung:
**26.08.87 Patentblatt 87/35**

(84) Benannte Vertragsstaaten:
**BE CH DE FR GB IT LI NL SE**

(56) Entgegenhaltungen:
**EP - A - 0 049 940**
**EP - A - 0 062 610**
**EP - A - 0 062 611**
**DE - A - 3 114 250**
**US - A - 4 352 723**
**US - A - 4 358 477**

(73) Patentinhaber: **CIBA-GEIGY AG, Klybeckstrasse 141, CH-4002 Basel (CH)**

(72) Erfinder: **Goodin, Jonathan William, Dr., 2 Westland Terrace, North Street Cambridge CB4 3QT (GB)**
Erfinder: **Irving, Edward, Dr., 41, Swaffham Road, Burwell Cambridge CB5 OAN (GB)**

**EP 0 126 029 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die Erfindung betrifft ein neues Verfahren zur Bilderzeugung durch Erhitzen und anschliessende Bestrahlung mit aktinischem Licht.

Die Bilderzeugung mittels Photopolymerisation wird im allgemeinen so vorgenommen, dass man ein Substrat mit einer Lösung einer photopolymerisierbaren Substanz in einem flüchtigen organischen Lösungsmittel beschichtet, das Lösungsmittel verdampft oder verdampfen lässt, wobei ein Film der photopolymerisierbaren Substanz gebildet wird, den Film durch ein Negativ mit aktinischem Licht bestrahlt und so die bestrahlten Stellen des Films photopolymerisiert (und weniger löslich macht), während die nicht belichteten Stellen im wesentlichen unverändert bleiben, diese nicht belichteten, nicht photopolymerisierten Stellen des Films mit einem geeigneten Lösungsmittel, das die belichteten photopolymerisierten Stellen des Films nicht löst, entfernt. Diese letzte Stufe wird im allgemeinen «Entwickeln» genannt.

Wünschbar wäre ein Verfahren, bei dem ohne Verwendung von Lösungsmitteln eine Schicht aus photopolymerisierbarem Material auf ein Substrat appliziert und diese Schicht in einen im wesentlichen festen, klebefreien Zustand, bei dem dann die Bestrahlung erfolgen kann, übergeführt wird. In dieser Phase könnte nicht nur auf die Verwendung von Lösungsmitteln, die bezüglich Toxizität und Entflammbarkeit problematisch sein können und deren Rückgewinnung aufwendig ist, verzichtet werden, sondern es würde auch die Herstellung von beschichteten, für die Bestrahlung breiten Substrate in einem kontinuierlichen Verfahren erleichtert.

Es wurde gefunden, dass sich diese Aufgabe durch Verwendung bestimmter flüssiger Stoffzusammensetzungen mit Gruppen, über welche eine thermische Polymerisation und eine Photopolymerisation stattfinden können, lösen lässt. Die Gruppen werden so gewählt, dass eine Schicht aus dem flüssigen Stoffgemisch durch thermische Polymerisation rasch in eine feste, im wesentlichen klebefreie Schicht übergeführt wird, die jedoch in bestimmten Lösungsmitteln noch löslich ist. Falls erwünscht, werden bestimmte Teile der Schicht mit aktinischem Licht bestrahlt, wobei in der schon termisch polymerisierten Schicht eine Photopolymerisation erfolgt und die photopolymerisierten Stellen der Schicht in dem Lösungsmittel viel weniger löslich werden.

In der EP-A-0 062 610 wird ein Abbildungsverfahren beschrieben, bei dem eine flüssige Schicht eines photopolymerisierbaren Materials auf einen Träger aufgebracht, diese Schicht photochemisch vorgehärtet, bildmässig belichtet und anschliessend entwickelt wird. Eine thermische Verhärtung wird nicht erwähnt.

In der U.S. Patentschrift 4 291 118 ist ein Verfahren zur Herstellung von Reliefbildern aus einem Film aus flüssigem photopolymerisierbarem Material beschrieben. Dabei wird der Film bis zur Verfestigung einer chemischen Härtung unterzogen, und der verfestigte Film wird in einem bestimmten Muster so behandelt, dass in dem verfestigten Film entsprechend dem Muster an den behandelten und nicht behandelten Stellen unterschiedliche chemische Zustände entstehen. Anschliessend wird selektiv der Teil der Masse in dem einen entfernt, wobei der Teil der Masse in dem anderen chemischen Zustand ein Reliefbild bildet. Um die unterschiedlichen chemischen Zustände zu erzeugen, wird in allen beschriebenen Ausführungsformen aktinisches Licht angewendet, obwohl in der Beschreibung angegeben wird, eine weitere Möglichkeit bestehe in der Anwendung von Wärme. Bei dem in dieser U.S. Patentschrift beschriebenen Verfahren wird somit der Film aus flüssigem Material mit aktinischem Licht bestrahlt, und der verfestigte Film wird dann erneut in einem vorgegebenen Muster mit aktinischem Licht bestrahlt, so dass ein Teil oder bestimmte Teile des Films sich weniger leicht durch Lösungsmittel entfernen lassen. Schliesslich wird das Bild entwickelt, indem man die leichter entfernbaren, d.h. die nicht ein zweites Mal bestrahlten Stellen, mit einem Lösungsmittel auswäscht. Die Bestrahlungsbedingungen müssen bei diesem Verfahren sehr genau eingehalten werden. Bei ungenügender Bestrahlung in der ersten Stufe bleibt das verfestigte Material klebrig und unangenehm in der Handhabung. Wird es zuviel bestrahlt, so erhält man Bilder mit ungenügender Auflösung. Es wird nur die Verwendung von photopolymerisierbaren Polyen-Polythiol-Stoffgemischen beschrieben. Diese haben den Nachteil, dass die durch die thermische Behandlung oder die Bestrahlung mit aktinischem Licht initiierte Polymerisation weitergeht, wenn die thermische Behandlung oder die Bestrahlung unterbrochen werden. Daraus folgt, dass zum Erzielen Bilder guter Qualität die zweite Bestrahlung sofort vorgenommen werden muss. Dies beeinträchtigt die industrielle Anwendung dieses Verfahrens.

Aus der DE-A-31 14 250 sind photohärtbare Harzmassen bekannt. Ein Abbildungsverfahren umfassend die thermische Vorhärtung einer flüssigen Schicht und daran anschliessend eine bildmässige Belichtung ist dort nicht offenbart.

In den U.S. Patentschriften 4 288 527 und 4 352 723 sind acrylat-haltige Stoffgemische beschrieben, die in beliebiger Reihenfolge oder gleichzeitig mit UV-Strahlung oder Wärme zu festen Produkten ausgehärtet werden können, die als Beschichtungen, Dichtungen, Resistmaterialien und dergleichen verwendet werden können. Die Stoffgemische können katalytische Mengen eines Pinakols, einen Photoinitiator und gegebenenfalls ein copolymerisierbares Monomer oder reaktives Verdünnungsmittel enthalten. Diese Patentschriften offenbaren kein Verfahren, bei dem ein flüssiges Stoffgemisch zuerst durch Hitze polymerisiert und anschliessend durch selektive UV-Bestrahlung ein Bild erzeugt wird. In diesen Patentschriften wird ebenfalls kein Verfahren erwähnt, bei dem ohne Verlust an Bildqualität zwischen dem Erhitzen und der UV-Bestrahlung ein

zeitlicher Abstand in Kauf genommen werden kann.

Es wurde nun gefunden, dass sich die Nachteile der vorbekannten Verfahren durch Verwendung von Stoffgemischen, die sowohl äthylenische als auch photopolymerisierbare Gruppen in demselben oder verschiedenen Molekülen aufweisen, vermeiden lassen.

Es ist seit langem bekannt, dass sich Polymere mit seitenständigen photopolymerisierbaren Gruppen durch radikalisch initiierte thermische Polymerisation von Acrylaten mit photopolymerisierbaren Gruppen herstellen lassen. Die festen Polymeren werden im allgemeinen als Lösungen in flüchtigen organischen Lösungsmittel hergestellt. Durch Beschichten von Substraten, wie kupferkaschierten Laminaten, mit solchen Lösungen und Verdampfen der Lösungsmittel werden darauf Filme erzeugt. Das Bedürfnis nach Verfahren zur Bilderzeugung, bei denen auf das Verdampfen organischer Lösungsmittel verzichtet werden kann, welche jedoch zulassen, dass ein ein Bild aufweisendes Transparent mit dem photopolymerisierbaren Material in Berührung gebracht werden kann, wird durch die oben erwähnte U.S. Patentschrift 4 291 118 veranschaulicht, obwohl das in dieser Patentschrift beschriebene Verfahren aus den angegebenen Gründen nicht ganz zufriedenstellend ist.

Trotz des durch die genannte U.S. Patentschrift veranschaulichten Bedürfnisse und obwohl die Herstellung photopolymerisierbarer Polymere aus Acrylaten seit langem bekannt ist, wurde noch nie vorgeschlagen, flüssige Acrylate mit photopolymerisierbaren Resten auf dem Substrat, auf dem das Bild erzeugt werden soll, thermisch zu polymerisieren und damit eine feste, noch bildmässig photopolymerisierbare Schicht zu bilden.

Es wurde nun gefunden, dass sich überraschenderweise flüssige Stoffgemische, die in demselben oder in verschiedenen Molekülen eine Acrylatgruppe oder eine andere thermisch polymerisierbare ungesättigte Gruppe und eine photopolymerisierbare Gruppe aufweisen, auf einem Trägermaterial, wie kupferkaschierten Laminaten, ohne Verwendung von flüchtigen organischen Lösungsmitteln thermisch polymerisieren lassen, wobei eine feste, aber noch härtbare Schicht entsteht. Diese Schicht kann anschliessend bildmässig mit aktinischem Licht bestrahlt werden, wobei die belichteten Stellen ausgehärtet werden und die nichtbelichteten Stellen in einem Entwickler löslich bleiben.

Gegenstand der Erfindung ist somit ein Verfahren zur Bilderzeugung durch

(i) Erhitzen einer auf einem Trägermaterial applizierten Schicht aus einem flüssigem Stoffgemisch, das

(A) eine Verbindung mit mindestens einer hitze-polymerisierbaren äthylenisch ungesättigten Gruppe,

(B) ein photopolymerisierbares Material und

(C) einen hitze-aktivierbaren freien Radikal-Initiator für die Polymerisation von (A) enthält, auf Temperaturen, bei denen der Initiator (C) aktiviert wird, wobei das Material (A) über seine hitze-polymerisierbaren äthylenisch ungesättigten Gruppen polymerisiert wird und sich die Schicht verfestigt, jedoch noch photopolymerisierbar bleibt,

(ii) anschliessende Bestrahlung der verfestigten Schicht in einem vorgegebenen Muster mit aktinischem Licht, derart, dass die belichteten Stellen der Schicht photopolymerisiert werden, und

(iii)entfernen der im wesentlichen nicht photopolymerisierten Stellen der Schicht durch Behandlung mit einem dafür geeigneten Lösungsmittel.

Der Ausdruck «Bestrahlung in einem vorgegebenen Muster» umfasst sowohl das Belichten durch ein ein Bild aufweisendes Transparent als auch das Belichten mit einem computergesteuerten, ein Bild erzeugenden Laserstrahl.

Die erfindungsgemäss verwendeten Stoffgemische können ein Gemisch aus einer oder mehreren hitze-polymerisierbaren Substanzen (A) und einer oder mehreren Substanzen (B), die ausschliesslich photopolymerisierbar sind, enthalten. Andererseits können die genannten Stoffgemische auch eine oder mehrere sog. «doppelfunktionelle» Substanzen enthalten d.h. Substanzen, die sowohl hitze-polymerisierbar als auch photopolymerisierbar sind, besonders Substanzen, welche in demselben Molekül eine oder mehrere hitze-polymerisierbare äthylenisch ungesättigte Gruppen und eine oder mehrere Gruppen, die ausschliesslich photopolymerisierbar sind, aufweisen. Bei dieser Ausführungsform sind (A) und (B) identisch. Gemäss einer weiteren Ausführungsform kann die Stoffzusammensetzung ein Gemisch aus einer oder mehreren doppelfunktionellen Substanzen und einer oder mehreren hitze-polymerisierbaren Substanzen und/oder einer oder mehreren ausschliesslich photopolymerisierbaren Substanzen enthalten.

Bei der ersten Stufe des erfindungsgemässen Verfahrens wird das Stoffgemisch im allgemeinen auf Temperatur zwischen 80 und 150 °C, bevorzugt 100 und 120 °C, erhitzt, üblicherweise bis zu 50 Minuten, besonders 2–30 Minuten.

Es ist daher im allgemeinen wünschenswert, dass die hitze-polymerisierbare Verbindung (A) und das photopolymerisierbare Material (B) bei Normaldruck je einen Siedepunkt über 100 °C, vorzugsweise über 120 °C und besonders bevorzugt über 150 °C aufweisen, damit merkliche Materialverluste während des Erhitzens vermieden werden können.

Die ungesättigten Gruppen in (A) können aliphatisch oder cycloaliphatisch und an gesättigte oder ungesättigte aliphatische Kohlenstoffatome, an aromatische Kohlenwasserstoffatome, an Sauerstoffatome oder Carbonylgruppen gebunden sein. Geeignete Materialien sind beispielsweise Styrole, allylische Verbindungen, Cyclohexene und Acrylsäureester.

Bevorzugte hitze-polymerisierbare Materialien (A) sind:

a) gegebenenfalls substituierte Styrole der Formel I

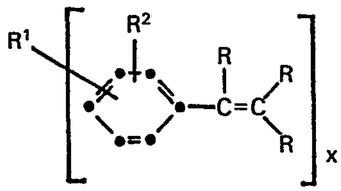
(I),

worin die Gruppen R unabhängig voneinander ein Wasserstoffatom oder eine Alkylgruppe mit 1–4 C-Atomen bedeuten,

x 1 oder 2 ist und

$R^1$ bei x = 1, ein Wasserstoffatom oder eine Alkylgruppe mit 1–4 C-Atomen, bei x = 2, eine Alkylengruppe mit 1–4 C-Atomen, ein Sauerstoff- oder Schwefelatom, eine Carbonyl- oder Sulfonylgruppe und

$R^2$ ein Wasserstoff- oder Halogenatom, eine Alkylgruppe mit 1–4 C-Atomen, eine Hydroxylgruppe, eine Glycidyloxygruppe oder den Rest einer Glycidyloxygruppe nach der Umsetzung mit einem Phenol oder einer Carbonsäure darstellen,

b) allylische Verbindungen der Formel IIA oder IIB

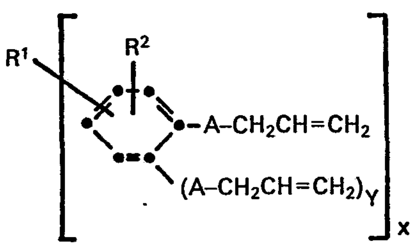
(IIA) oder

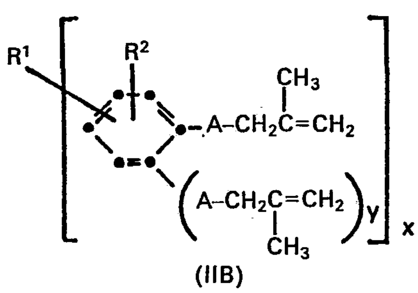
(IIB)

worin $R^1$, $R^2$ und x die unter Formel I angegebene Bedeutung haben, y Null oder 1 ist und A eine kovalente Bindung, ein Sauerstoffatom oder eine Carbonyloxygruppe bedeutet,

c) Cyclohexene der Formel IIIA oder IIIB

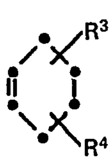
oder
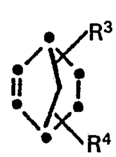

(IIIA) (IIIB)

worin $R^3$ und $R^4$ unabhängig voneinander ein Wasserstoff- oder Halogenatom, eine Alkylgruppe mit 1–6 C-Atomen, eine Carboxylgruppe oder eine gegebenenfalls eine Epoxidgruppe enthaltende Estergruppe mit 3–10 C-Atomen bedeuten,

d) Acrylsäureester mit mindestens einer Gruppe der Formel IV

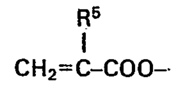
(IV),

worin $R^5$ ein Wasserstoff-, Chlor- oder Bromatom oder eine Alkylgruppe mit 1–4 C-Atomen darstellt.

Als Styrole der Formel I eignen sich z.B.: Styrol, α-Methylstyrol, β-Methylstyrol, 4-Bromstyrol, 4-Methylstyrol, 4-Vinylphenol, 1-propenylsubstituierte Bisphenole wie 2,2-Bis[4-hydroxy-3(1-propenyl)phenyl]-propan, und 1-propenylsubstituierte Bisphenoldiglycidyläther, wie 2,2-Bis[4-glycidyloxy-3(1-propenyl)phenyl]-propan.

Beispielsweise von geeigneten allylischen Verbindungen der Formel IIA oder IIB sind: allyl- und methallyl-substituierte einwertige Phenole, allyl- und methallyl-substituierte Bisphenole, wie 2,2-Bis[-4-hydroxy-3-(2-propenyl)phenyl]propan, allyl- und methallyl-substituierte Bisphenoldiglycidyläther, wie 2,2-Bis[4-glycidyloxy-3-(2-propenyl)phenyl]propan, Allyl- und Methallyläther von einwertigen Phenolen und Bisphenolen sowie Allyl- und Methallylester von aromatischen Carbonsäuren, besonders von zwei- und anderen mehrwertigen Carbonsäuren, wie Diallylphthalat und Diallyl-, Dimethallyl-, Tetraallyl- und Tetramethallylester der Benzophenon-3,4,3',4'-tetracarbonsäure.

Als Acrylsäureester mit mindestens einer Gruppe der Formel IV eignen sich z.B. Acrylate und 2-substituierte Acrylate von einwertigen Alkoholen, wie 2-Methoxyäthanol, 2-(Cyanäthanol, Furfurylalkohol, Glycidyl und Cyclohexanol, sowie vollständig oder teilweise veresterte mehrwertige Alkohole, wie Butandiol, Pentaerythrit, Dipentaerythrit, Tri- und Tetraäthylenglykole, Trimethylolpropan und Glycerin. Geeignet sind ferner durch Umsetzung von Alkylenoxiden, besonders Äthylenoxid oder Propylenoxid mit einer Acrylsäure erhaltene Ester, besonders 2-Hydroxyäthyl- und 2-Hydroxypropylacrylate und -methacrylate. Es können auch Ester verwendet werden, die man durch Umsetzung einer Verbindung mit einer oder mehreren Glycidylgruppen, besonders Mono- oder Polyglycidyläthern eines ein- oder mehrwertigen Alkohols oder Phenols, oder eines N-Glycidylhydantoins, mit Acrylsäure oder Methacrylsäure erhält. Weitere geeignete Ester sind Reaktionsprodukte aus einem Diepoxid und einem Addukt aus einem Hydroxyalkylacrylat oder 2-substituierten Acrylat und einem gesättigten oder ungesättigten Dicarbonsäureanhydrid, wie Bernsteinsäure-, Maleinsäure- oder Phthalsäureanhydrid.

Als weitere geeignete Acrylate seien Acrylurethane, erhalten durch Umsetzung eines aromatischen oder aliphatischen Mono- oder Polyisocyanats mit einem Hydroxylalkylacrylat, und Acrylamine, hergestellt durch Veresterung eines tertiären Aminoalkohols oder Aminophenols mit einer Acrylsäure, besonders durch Umsetzung eines tertiären Aminoalkanols mit Acryl- oder Methacrylsäure erhaltene Acrylamine, genannt.

Als erfindungsgemäss einsetzbare Materialien (B), die ausschliesslich photopolymerisierbar sind, kommen solche in Betracht, bei denen die Polymerisation durch direkte Aktivierung lichtempfindlicher Gruppen mittels Bestrahlung erfolgt, oder bei denen die Bestrahlung ein geeignetes Initiatormolekül aktiviert, das dann seinerseits die photopolymerisierbaren Gruppen aktiviert.

Materialien mit lichtempfindlichen Gruppen sind an sich bekannt, wie z.B. Materialien mit zwei und vorzugsweise drei oder mehr Azido-, Cumarin-, Stilben-, Maleinimid-, Pyridinon-, Chalkon-, Propenon-, Pentadienon-, Anthracen- oder Acrylsäureestergruppen, die in 3-Stellung durch eine äthylenisch ungesättigte oder eine Gruppe aromatischen Charakters in Konjugation mit der äthylenischen Doppelbindung der Acrylgruppe substituiert sind.

Als Materialien, bei denen die Photopolymerisation durch Aktivierung eines Photoinitiators erfolgt, der seinerseits polymerisierbare Gruppen aktiviert, eignen sich beispielsweise Epoxidharze, phenolische Harze, Harnstoff-Formaldehyd-Harze, cyclische Äther, cyclische Ester, cyclische Sulfide, cyclische Amine und cyclische Organosilikonverbindungen in Kombination mit strahlungsempfindlichen aromatischen Oniumsalzen, wie Diazonium-, Sulfonium-, Jodonium- und Sulfoxoniumsalzen, oder einem strahlungsempfindlichen aromatischen Jodosylsalz.

Als Azide eignen sich z.B. Verbindungen mit mindestens zwei Grzppen der Formel V

$N_3Ar-$ (V),

worin Ar einen einkernigen oder zweikernigen zweiwertigen aromatischen Rest mit insgesamt 6–14 C-Atomen, besonders eine Phenylen- oder Naphthylengruppe bedeutet.

Beispiele geeigneter Cumarine sind Verbindungen mit Gruppen der Formel VI

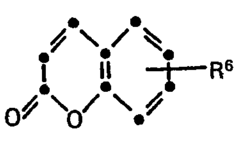

(VI),

worin $R^6$ ein Sauerstoffatom, eine Carbonyloxygruppe (–COO–), eine Sulfonyl- oder Sulfonyloxygruppe darstellt.

Beispiele von stilbengruppenhaltigen Verbindungen sind solche mit Gruppen der Formel VII

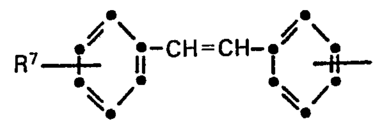

(VII),

worin $R^7$ den Rest eines insgesamt bis zu 8 C-Atome aufweisenden 5- oder 6-gliedrigen stickstoffhaltigen heterocyclischen Ringes bedeutet, der mit einem Benzol- oder Naphthalinring kondensiert und über ein Kohlenstoffatom des Heterocyclus, das sich in ortho-Stellung zu einem N-Atom des Heterocyclus befindet, an den angegebenen Benzolring gebunden ist, wie z.B. Benzimidazolyl-, Benzoxazolyl-, Benztriazolyl-, Benzthiazolyl- oder Naphthotriazolylreste.

Beispiele von Verbindungen mit Maleinimidgruppen sind solche mit Gruppen der Formel VIII

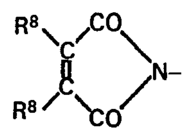

(VIII),

worin die $R^8$ Alkyl mit 1–4 C-Atomen, ein Chloratom oder eine Phenylgruppe und besonders eine Methylgruppe bedeuten.

Als Verbindungen mit Pyridinongruppen eignen sich z.B. solche mit Gruppen der Formel IX

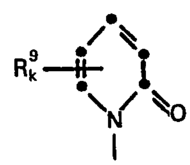

(IX),

worin $R^9$ ein aliphatischer oder cycloaliphatischer Rest mit bis zu 8 C-Atomen und k Null oder eine ganze Zahl von 1–4 bedeuten.

Als Verbindungen mit Chalkon-, Propenon- und Pentadienongruppen kommen solche mit Gruppen der Formel X oder XI

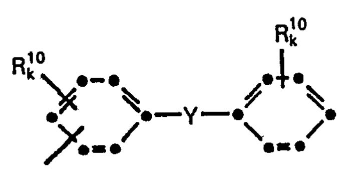

oder

(X)

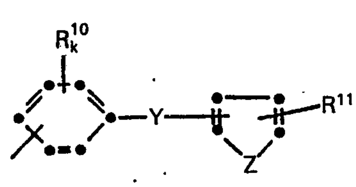

(XI)

in Betracht, worin die $R^{10}$ ein Halogenatom, eine Alkyl-, Cycloalkyl-, Alkenyl-, Cycloalkenyl-, Alkoxy-, Cycloalkoxy-, Alkenyloxy-, Cycloalkenyloxy-, Alkoxycarbonyl-, Cycloalkyloxycarbonyl-, Alkenyloxycarbonyl- oder Cycloalkenyloxycarbonylgruppe mit je bis zu 9 C-Atomen, eine Nitrogruppe, eine Carbonsäure-, Sulfonsäure- oder Phosphorsäuregruppe in Salzform bedeuten,

k die oben angegebene Bedeutung hat,

$R^{11}$ eine direkte Bindung oder ein Wasserstoffatom, und

Y eine Gruppe der Formel XII, XIII oder XIV

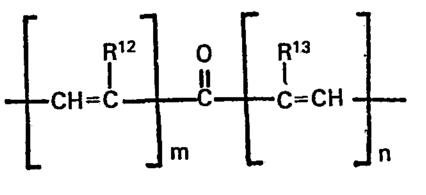 , (XII)

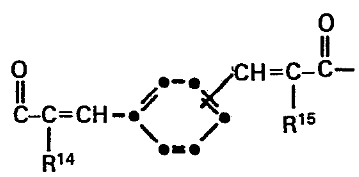

(XIII) oder

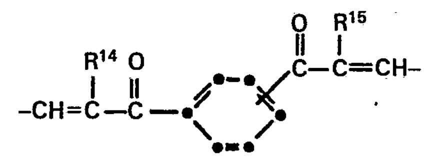

(XIV)

darstellen, worin

$R^{12}$ und $R^{13}$ unabhängig voneinander ein Wasserstoffatom, eine Alkylgruppe mit z.B. 1–4 C-Atomen oder eine Arylgruppe, besonders eine einkernige Arylgruppe, wie die Phenylgruppe, oder $R^{12}$ und $R^{13}$ zusammen eine Polymethylenkette mit 2–4 Methylengruppen,

$R^{14}$ und $R^{15}$ unabhängig voneinander ein Wasserstoffatom, eine Alkylgruppe mit z.B. 1–4 C-Atomen oder eine Arylgruppe, vorzugsweise eine einkernige Gruppe, wie die Phenylgruppe, m und n unabhängig voneinander Null, 1 oder 2, aber nicht beide Null und

Z eine Sauerstoff- oder Schwefelatom bedeuten.

Geeignete Anthracene sind solche mit Anthrylgruppen, wie die 1-, 2- oder 9-Anthrylgruppe, die unsubstituiert oder durch eine oder zwei Brom- oder Chloratome, Methyl- oder Nitrogruppen substituiert sein können.

Als 3-substituierte Acrylate eignen sich z.B. solche der Formel XV

$$R^{16}\text{–CH=C}(R^5)\text{COO–} \qquad \text{(XV)},$$

worin $R^{16}$ eine aliphatische oder einkernige aromatische, araliphatische oder heterocyclische Gruppe darstellt, die – wie schon erwähnt – ungesättigt sind oder in Konjugation mit der angegebenen äthylenischen Doppelbindung aromatischen Charakter haben, wie z.B. die Phenyl-, 2-Furyl-, 2- oder 3-Pyridyl-, Prop-2-enyl- oder Styrylgruppe und $R^5$ die oben angegebene Bedeutung hat.

Als Beispiel solcher Verbindungen seien die Disorbinsäureester von Poly(oxyalkylen)glykolen, Polyvinylzimtsäureester und Reaktionsprodukte aus Epoxidharzen und Zimtsäure genannt.

Oniumsalze, die in Kombination mit Epoxidharzen oder anderen kationisch polymerisierbaren Substanzen photopolymerisierbare Mischungen ergeben, sind in den U.S. Patentschriften 4 058 400 und 4 058 401 beschrieben. Sulfoxoniumslaze, die für denselben Zweck eingesetzt werden können, sind in der U.S. Patenschrift 4 299 938, und in den europäischen Patentanmeldungen EP-A-35 969 und EP-A-44 274 beschrieben.

Aromatische Jodosylsalze, die in Kombination mit kationisch polymerisierbaren Substanzen photopolymerisierbare Gemische ergeben, sind z.B. solche der Formel $[(Ar^1)(Ar^2)IO^+]_tX^{t-}$, worin

$Ar^1$ und $Ar^2$ unabhängig voneinander einen einwertigen aromatischen Rest mit 4–25 C-Atomen,

$X^{t-}$ ein t-wertiges Anion einer Protonensäure und

t 1, 2 oder 3 bedeuten.

$Ar^1$ und $Ar^2$ sind vorzugsweise Phenyl, wobei die Phenylringe durch eine Alkylgruppe mit 1–4 C-Atomen, ein Halogenatom oder eine Nitrogruppe substituiert sein können.

Die Anionen $X^{t-}$ werden so gewählt, dass eine wirksame Härtung eintritt. Aufeinander abgestimmt kationisch polymerisierbare Materialien und geeignete Anionen können vom Fachmann auf dem Gebiet der Härtung oder Polymerisation kationisch polymerisierbarer Stoffgemische leicht ermittelt werden. Salze mit Anionen, die sich von organischen Carbonsäuren, organischen Sulfonsäuren und anorganischen Säuren ableiten, besonders Acetate, Trifluoroacetate, Methansulfonate, Benzolsulfonate, p-Toluolsulfonate, Trifluormethansulfonate, Fluoride, Chloride, Bromide, Jodate, Perchlorate, Nitrate, Sulfate, Hydrogensulfate, Phosphate oder Hydrogenphosphate eignen sich z.B. zum Härten von Phenoplasten, wie Phenol-Formaldehydharzen, und Aminoplasten, wie Harnstoff-Formaldehydharzen. Salze mit einem Pentafluorhydroxoantimonat-Anion oder einem Metallhalogenid- oder Metalloidhalogenid-Anion der Formel $MQ^-_w$, worin

M das Atom eines Metalls oder Metalloids,

Q ein Halogenatom und

w eine ganze Zahl von 4 bis 6 bedeuten, wobei w um eines grösser ist als die Wertigkeit von M, eignen sich zum Härten von Epoxidharzen und Episulfidharzen.

Bevorzugte Anionen $MQ^-_w$ sind das Hexafluorantimonat-, Hexachlorantimonat-, Hexafluorarsenat-, Tetrachlorferrat-, Hexachlorstannat-, Tetrafluorborat- oder Hexafluorphosphat-Anion,

wobei die beiden letztgenannten besonders bevorzugt sind.

Die Diaryljodosylsalze können analog den von F.M. Beringer und P. Bodlaender in J. Org. Chem., 33, 2981–4 (1968) beschriebenen Methoden hergestellt werden.

Für das erfindungsgemässe Verfahren geeignete doppelfunktionelle Substanzen enthalten eine oder mehrere äthylenisch ungesättigte Gruppen, die unter den Bedingungen gemäss Verfahrensstufe (i) polymerisieren, sowie eine oder mehrere photopolymerisierbare Gruppen wie im Vorangehenden beschrieben, die bei Bestrahlung oder Aktivierung durch ein bestrahltes Molekül polymerisieren. Solche Materialien können dadurch hergestellt werden, dass man eine oder mehrere äthylenisch ungesättigte Gruppen, besonders Acrylsäureestergruppen, in Verbindungen, die schon eine oder mehrere photopolymerisierbare Gruppen und auch eine oder mehrere reaktive Gruppen, wie Carbonsäuregruppen, phenolische oder alkoholische Hydroxylgruppen, Epoxid- oder Imidgruppen enthalten, einführt. Bevorzugt sind Materialien mit einer oder mehreren Acrylsäureestergruppen, d.h. einer oder mehreren Gruppen der Formel IV und einer oder mehreren Gruppen der Formeln V, VI, VIII, X, XI oder XV, oder einer oder mehreren Anthracen- oder Epoxidgruppen.

Als Beispiele von Klassen von Verbindungen mit einer photopolymerisierbaren Gruppe und einer Carbonsäuregruppe kommen in Betracht: azidoaromatische Säuren, carboxyl-substituierte Stilbenderivate, wie Stilbenbenzimidazole, Stilbenbenzoxazole, Stilbenbenztriazole, Stilbennaphthotriazole und Stilbenbenzthiazole; carboxylgruppenhaltige Maleinimide, worin die beiden äthylenischen C-Atome des Maleinimidrings durch Alkylgruppen mit 1–4 C-Atomen, Phenylgruppen oder Chloratome substituiert sind; Anthracencarbonsäuren und Acrylsäuren, die in 3-Stellung durch äthylenisch ungesättigte Gruppen oder Gruppen aromatischen Charakters in Konjugation mit der äthylenischen Doppelbindung in 2,3-Stellung substituiert sind.

Als Klassen von Verbindungen mit einer photopolymerisierbaren Gruppe und einer phenolischen Hydroxylgruppe kommen z.B. hydroxysubstituierte Chalkone und Anthracene sowie hydroxyphenyl-substituierte Propenone und Pentadienone in Betracht. Beispiele von Klassen von Verbindungen mit mit einer photopolymerisierbaren Gruppe und einer alkoholischen Hydroxylgruppe sind hydroxy-substituierte Maleinimide, hydroxy-substituierte Pyridione und anthryl-substituierte Alkohole. Derartige hydroxylgruppenhaltige Verbindungen können direkt mit den äthylenisch ungesättigten Verbindungen, die eine hydroxyl-reaktive Gruppe aufweisen, umgesetzt werden, oder sie können zuerst in die entsprechenden Glycidyläther übergeführt werden, die dann mit den äthylenisch ungesättigten Verbindungen umgesetzt werden.

Als Klassen von Verbindungen mit einer photopolymerisierbaren Gruppe und einer Imidgruppe seien disubstituierte Maleinimide, worin die beiden äthylenischen C-Atome des Maleinimidringes wie oben angegeben substituiert sind, erwähnt.

Geeignete azidoaromatische Säuren sind 4-Azidobenzoesäuren und andere Verbindungen der Formel XVI

$$N_3\text{-Ar-COOH} \quad \text{(XVI)},$$

worin Ar die oben angegebene Bedeutung hat.

Beispiele von geeigneten carbonsäuregruppenhaltigen Stilbenderivaten sind 4-(1-Methylbenzimidazol-2-yl)stilben-4'-carbonsäure, 4-(2H-Naphtho[1,2-d]triazol-2-yl)stilben-4'-carbonsäure und andere Verbindungen der Formel XVII

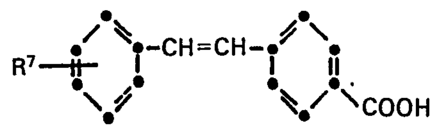

(XVII),

worin $R^7$ die oben angegebene Bedeutung hat.

Als carbonsäuregruppenhaltige Maleinimide eignen sich z.B.N-(Carboxyphenyl)dimethylmaleinimid und andere Verbindungen der Formel XVIII

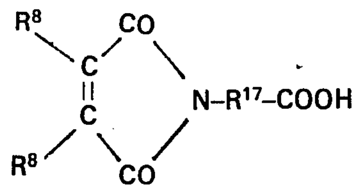

(XVIII),

worin $R^8$ die oben angegebene Bedeutung hat und

$R^{17}$ einen aromatischen, aliphatischen oder cycloaliphatischen Aminocarbonsäurerest mit bis zu 14 C-Atomen nach Entfernen einer primären Aminogruppe und einer Carbonsäuregruppe darstellt.

Als hydroxy-substituierte Chalkone und hydroxyphenyl-substituierte Propenone und Pentadienone kommen z.B. 1-(4-Hydroxyphenyl)-3-oxo-3-phenylprop-1-en, 1-(4-Hydroxyphenyl)-1-oxo-3-phenyl-prop-2-en, 1-(2-Furyl)-3-oxo-3-(4-hydroxyphenyl)prop-1-en und andere Verbindungen der Formel XIX oder XX

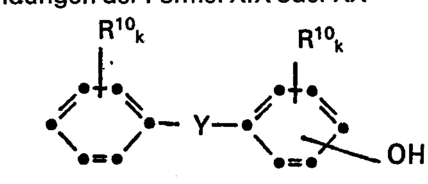

(XIX) oder

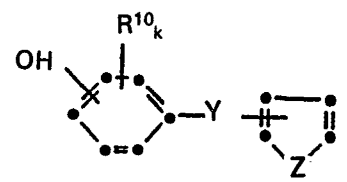

(XX)

in Betracht, worin $R^{10}$, k, Y und Z die oben angegebenen Bedeutungen haben.

Als Beispiele von hydroxy-substituierten Maleinimiden und hydroxysubstituierten Pyridionen seien genannt: N-(2-Hydroxyäthyl)dimethylmaleinimid, 4,6-Dimethyl-1-(2'-hydroxyäthyl)pyridin-2-on und weitere Verbindungen der Formel XXI oder XXII

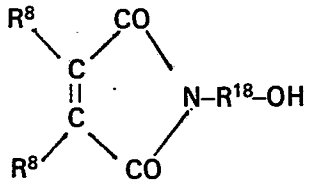

(XXI)

oder

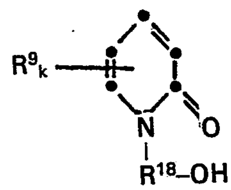

(XXII),

worin $R^8$, $R^9$ und k die oben angegebene Bedeutung haben und $R^{18}$ den Rest eines aliphatischen oder cycloaliphatischen Aminoalkohols mit höchstens 8 C-Atomen nach Entfernen einer Aminogruppe und einer alkoholischen Hydroxylgruppe darstellt.

Geeignete Imide sind Dimethylmaleinimid und andere Verbindungen der Formel XXIII

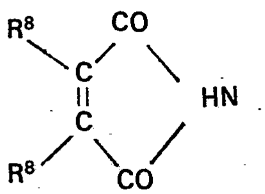

(XXIII),

worin die $R^8$ die oben angegebene Bedeutung haben.

Als anthracen-haltige Carbonsäuren kommen z.B. Anthracen-1-carbonsäure, Anthracen-2-carbonsäure und Anthracen-9-carbonsäure in Betracht, Geeignete hydroxy-substituierte Anthracene sind z.B. 1-Anthranol und 2-Anthranol. Beispiele von anthryl-substituierten Alkoholen sind 1-Hydroxymethylanthracen, 9-Hydroxymethylanthracen und 1-(2'-Anthryl)-äthanol.

Als 3-substituierte Acrylsäuren kommen Zimtsäure und weitere Säuren der Formel XXIV

$$R^{16}-CH=C(R^5)COOH \qquad (XXIV)$$

in Betracht, worin $R^5$ und $R^{16}$ die oben angegebenen Bedeutungen haben.

Die äthylenisch ungesättigten Gruppen können nach an sich bekannten Methoden in solche Verbindungen eingeführt werden, z.B. durch Veresterung einer athylenisch ungesättigten Säure, wie z.B. einer Acrylsäure, oder eines reaktiven Derivats einer solchen Säure, z.B. eines Glycidylmethacrylats, oder durch Veresterung eines äthylenisch ungesättigten Alkohols, wie Hydroxyäthylmethacrylat.

Weitere geeignete doppelfunktionelle Substanzen sind z.B. solche mit einer oder mehreren hitze-polymerisierbaren äthylenisch ungesättigten Gruppen und einer oder mehreren Epoxidgruppen, in Gegenwart eines strahlungsempfindlichen aromatischen Oniun- oder Jodosyl-Salzes.

So können z.B. in Gegenwart derartiger Salze die Styrole der Formel I und die allylischen Verbindungen der Formel IIA oder IIB, worin $R^2$ eine Glycidyloxygruppe ist, und die Cyclohexene der Formel IIIA oder IIIB, worin $R^3$ und/oder $R^4$ eine Epoxidgruppe enthalten, als doppelfunktionelle Materialien eingesetzt werden.

Als weitere Substanzen, die in Gegenwart eines strahlungsempfindlichen aromatischen Onium- oder Jodosyl-Salzes als doppelfunktionelle Materialien verwendet werden können, seien Verbindungen, die sowohl eine Epoxidgruppe als auch eine Acrylsäureestergruppe enthalten, genannt, besonders Verbindungen der Formeln XXV, XXVI und XXVII

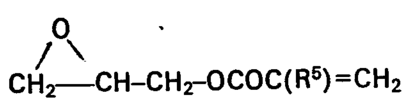

,

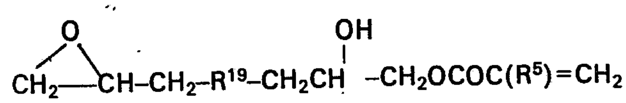

(XXV) (XXVI)

und

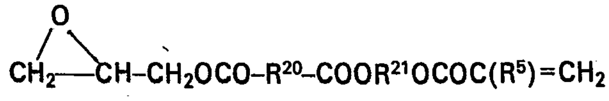

(XXVII),

worin $R^5$ die oben angegebene Bedeutung hat,

$R^{19}$ den Rest einer Polyglycidylverbindung nach Entfernen von zwei Glycidylgruppen,

$R^{20}$ den Rest einer Polycarbonsäure nach Entfernen von zwei Carbonsäuregruppen und

$R^{21}$ eine Alkylenkette mit 1–6 C-Atomen bedeuten.

Beispiele von geeigneten Resten $R^{19}$ sind Reste von zweiwertigen Phenolen, besonders Bisphenolen, nach Entfernen von zwei phenolischen Wasserstoffatomen, nach Entfernen von zwei alkoholischen Wasserstoffatomen erhaltene Glykolreste und nach Entfernen von zwei Amid-Wasserstoffatomen erhaltene Hydantoinreste. Als Beispiel von Resten $R^{20}$ seien nach Entfernen von zwei Carbonsäuregruppen erhaltene gesättigte oder ungesättigte aliphatische oder aromatische Dicarbonsäurereste und aromatische Tri- oder Tetracarbonsäurereste, wie Bernsteinsäure-, Malonsäure-, Maleinsäure-, Phthalsäure-, Trimellitsäure- und Pyromellitsäurereste, genannt. Als Alkylengruppen $R^{21}$ kommen z.B. Äthylen-, Propylen- und Butylengruppen in Betracht.

Die Verbindungen der Formeln XXV–XXVII können auch Verbindungen umfassen, wie sie oben zur Verwendung als hitze-polymerisierbare Materialien erwähnt wurden. In Abwesenheit von strahlungsempfindlichen kationischen Katalysatoren, wie aromatischen Onium- und Jodosyl-Salzen, sind die Epoxidgruppen dieser Verbindungen nicht photopolymerisierbar.

Die Verbindungen der Formeln XXV bis XXVII können durch Einführen von Gruppen der Formel IV, besonders Acrylat- oder Methacrylatgruppen, in Verbindungen, die schon eine oder mehrere 1,2-Epoxidgruppen enthalten, oder durch Einführung einer oder mehrerer 1,2-Epoxidgruppen in Verbindungen, die schon eine oder mehrere Gruppen der Formel IV enthalten, hergestellt werden.

Die Einführung von Gruppen der Formel IV in Verbindungen, die schon Epoxidgruppen enthalten, zur Herstellung von z.B. Verbindungen der Formel XXVI, erfolgt zweckmässig durch Umsetzung einer Epoxidverbindung mit mindestens zwei Epoxidgruppen mit einem stöchiometrischen Unterschuss, bezogen auf die vorhandenen Epoxidgruppen, einer Verbindung, die sowohl eine Gruppe der Formel IV als auch eine zur Reaktion mit 1,2-Epoxidgruppen befähigte Gruppe, wie eine Carbonsäuregruppe, eine phenolische oder alkoholische Hydroxylgruppe oder eine Imidgruppe enthält, wobei mindestens eine Gruppe der Formel IV in das Molekül eingeführt wird. Als Polyepoxide eignen sich z.B. Polyglycidylester von Polycarbonsäuren, wie Bernsteinsäure, Polyglycidyläther von mehrwertigen Alkoholen, wie Butan-1,4-diol, und mehrwertigen Phenolen, wie 2,2-Bis(4-hydroxyphenyl)propan, sowie Poly-(n-glycidyl)verbindungen, wie N,N'-Diglycidylhydantoine. Mit diesem Verfahren wird in der Regel keine 100%ige Ausbeute an Produkten erhalten, die in demselben Molekül sowohl eine 1,2-Epoxidgruppe als auch eine Acrylatgruppe der Formel IV enthalten. Das Produkt enthält auch Anteile an nicht umgesetztem Ausgangsprodukt mit der ursprünglichen Anzahl Epoxidgruppen sowie auch Material, in dem alle Epoxidgruppen durch Gruppen der Formel IV ersetzt wurden. Da jedoch solche Gemische im erfindungsgemässen Verfahren mit Erfolg eingesetzt werden können, spielt es keine Rolle, dass das Reaktionsprodukt ein Gemisch darstellt.

Die Einführung einer oder mehrerer Epoxidgruppen in Verbindungen mit mindestens einer Gruppe der Formel IV zur Herstellung von z.B. Verbindungen der Formeln XXV kann zweckmässig so erfolgen, dass man als Verbindung der Formel XXV eine solche verwendet, die mindestens auch eine alkoholische Hydroxylgruppe oder eine Carbonsäuregruppe aufweist, und die Verbindung derart behandelt, dass die genannten Gruppen in 1,2-Epoxidgruppen übergeführt werden. Dies erfolgt nach an sich für die Umwandlung von Hydroxyl- oder Carbonsäuregruppen in Glycidyläther- oder Glycidylestergruppen bekannten Methoden. So lässt man derartige Verbindungen z.B. in Gegenwart eines HCl-Akzeptors (im allgemeinen einer starken Base, z.B. NaOH) und vorzugsweise in Gegenwart eines Katalysators, wie einer quaternären Ammoniumverbindung, eines tertiären Amins, eines Übergangsmetallsalzes, eines Thioäthers oder eines Sulfoniumsalzes, mit Epichlorhydrin reagieren. Im allgemeinen wird das Epichlorhydrin im Überschuss über die theoretisch benötigte Menge eingesetzt. Dabei dient der Überschuss als Lösungsmittel für die Umsetzung, die normalerweise bei einer Temperatur zwischen 30 und 120 °C, vorzugsweise 40 und 65 °C, und üblicherweise zwecks Entfernung des bei der Reaktion gebildeten Wassers unter vermindertem Druck durchgeführt wird.

Verbindungen der Formel XXVII können zweckmässigerweise durch Überführung einer hydroxy-substituierten Verbindung mit einer Gruppe der Formel IV in einen Teilester durch Umsetzung mit einem Polycarbonsäureanhydrid hergestellt werden. Die freien Carbonsäuregruppen können dann nach dem oben erwähnten Verfahren glycidyliert werden, oder sie können durch Behandlung mit einer Verbindung mit zwei oder mehr Epoxidgruppen, im allgemeinen zwischen 60 und 120 °C in Gegenwart einer starken Base und eines Katalysators, wie einer quaternären Ammoniumverbindung oder eines Übergangsmetallsalzes, verestert werden.

Typische Verbindungen der Formeln XXV bis XXVII sind: Glycidylacrylat, Glycidylmethacrylat, 2-(4-Glycidyloxyphenyl)-2-[4-(3-acryloyloxy-2-hydroxypropoxy)phenyl]propan, 2-{4-(Glycidyloxyphenyl)-2- [4-(2-hydroxy-3- methacryloyloxy)propoxy]phenyl}propan, 1-(2-Methacryloyloxyäthoxycarbonyl)-2,4- und -2,5-bis-(glycidyloxycarbonyl)benzol, 1-(2-Acryloyloxyäthoxycarbonyl)-2,4- und -2,5-bis(glycidyloxycarbonyl)benzol, 2-Acryloyloxyäthoxyglycidylbernsteinsäureester, 2-Methacryloyloxyäthoxyglycidyl-bernsteinsäureester, 1-Glycidyl-3-(3-acryloyloxy-2-hydroxypropyl)-5,5-dimethylhydantoin, 1-Glycidyl -3-(2-hydroxy -3-methacryloyloxypropyl) -5,5-dimethylhydantoin, 1-Glycidyloxy-4- (3-acryloyloxy-2- hydroxypropyloxy)butan und 1-Glycidyloxy-4- (2-hydroxy-3-methacryloyloxypropyloxy)butan.

Die Photopolymerisation kann durch Bestrahlen in Gegenwart eines Photosensibilisators, wie 5-Nitroacenaphthen, 4-Nitroanilin, 2,4,7-Trinitro-9-fluorenon, 3-Methyl-1,3-diaza-1,9-benzanthron, Bis(dialkylamino)benzophenon, besonders Michler's Keton, d.h. Bis(p-dimethylamino)-benzophenon, und 2-Chlorthioxanthon, durchgeführt werden. Im allgemeinen werden 0,1 bis 20 Gew.-%, bevorzugt 0,5 bis 15 Gew.-%, Photopolymerisations-Katalysator, bezogen auf das Gewicht der photopolymerisierbaren Substanz, eingesetzt.

Besonders bevorzugt verwendet man im erfindungsgemässen Verfahren als photopolymerisierbare Materialien Gemische aus einem Epoxid, d.h. einer Verbindung mit durchschnittlich mehr als einer 1,2-Epoxidgruppe und einem Aryl-Onium-Hexafluorphosphat oder Jodosyl-Hexafluorphosphat. Derartige Gemische erfordern zur Förderung der Härtung des Harzes unter Lichteinfluss keinen Zusatz von Photosensibilisatoren.

Als thermisch aktivierbare freie Radikal-Initiatoren (C) können an sich beliebige Materialien eingesetzt werden, die beim Erhitzen unter den Bedingungen gemäss der Verfahrensstufe (i) des erfindungsgemässen Verfahrens freie Radikale bilden. Radikalbildner sind bekannt. Geeignet sind z.B. organische Peroxide und Hydroperoxide, Azoverbindungen und sterisch gehinderte phenyl-substituierte Alkane, wie 2,3-Dimethyldiphenylbutan und 3,4-Dimethyl-3,4-diphenylhexan. Als Radikalinitiatoren werden Azobis(isobutyronitril), Cumolhydroperoxid und Ketonperoxide, besonders Cyclohexanonperoxid und Äthylmethylketonperoxid, bevorzugt. Als Initiatoren (C) können auch aromatische Jodosyl-Salze verwendet werden. In Stoffgemischen, die ein kationisch polmerisierbares Material enthalten, können solche Jodosyl-Salze sowohl als Initiatoren (C) als auch als kationische Photopolymerisations-Katalysatoren wirken. Geeignete Jodosyl-Salze sind oben beschrieben. Zusammen mit den Initiatoren (C) können auch Beschleuniger für die radikalische Polymerisation, wie Sulfimide, Übergangsmetallsalze und tertiäre Amine, eingesetzt werden. Geeignete Trägermaterialien, auf denen die flüssigen Stoffgemische erfindungsgemäss polymerisiert werden können, sind z.B. Metalle, besonders Kupfer und Aluminium, faserverstärkte Verbundwerkstoffe, die gegebenenfalls durch Metall abgedeckt sind, und Silikon-Wafer.

In der zweiten Verfahrensstufe wird vorzugsweise aktinisches Licht mit einer Wellenlänge von 200–600 nm verwendet. Geeignete Quellen für aktinisches Licht sind z.B. Kohlebögen, Quecksilberdampflampen, Fluoreszenzlampen mit UV-Licht emittierenden Phosphoren, Argon- und Xenonglühlampen, Wolframlampen und photographische Flutlichtlampen. Quecksilberdampflampen, besonders Sonnenlampen, Fluoreszenzsonnenlampen und Metallhalogenidlampen sind besonders geeignet. Die erforderliche Belichtungszeit hängt von verschiedenen Faktoren ab, wie z.B. der Art der verwendeten Verbindungen, den Anteilen der verschiedenen Verbindungen im Stoffgemisch, der Art der Lichtquelle und dem Abstand der Lichtquelle von dem zu belichtenden Stoffgemisch. Geeignete Belichtungszeiten können vom Fachmann auf dem Gebiet der Photopolymerisation leicht durch Versuche ermittelt werden.

Nach der Belichtung werden die nicht belichteten Stellen mit einem Lösungsmittel ausgewaschen, wie Cyclohexanon, 2-Äthoxyäthanol, Toluol, Aceton und Gemische davon, sowie wässrige Säuren und Basen, wie verdünnte Salzsäure, wässriges Natriumcarbonat oder Natriumhydroxid. Die erfindungsgemässen Stoffgemische können somit zur Herstellung von Druckplatten und gedruckten Schaltungen verwendet werden. Die Verfahren zur Herstellung von Druckplatten und gedruckten Schaltungen aus photopolymerisierbaren Stoffgemischen sind allgemein bekannt.

Die Erfindung wird durch die folgenden Beispiele erläutert. Darin sind Teile und Prozente Gewichtsteile bzw. Gewichtsprozente.

Die verwendeten Harze werden wie folgt hergestellt:

Harz 1

Ein Gemisch aus 192 g Trimellitsäureanhydrid, 130 g 2-Hydroxyäthylmethacrylat, 1 g Tetramethylammoniumchlorid und 0,3 g hydrochinon wird in einem Reaktionsgefäss während 2 Stunden auf 60 °C erhitzt. Nach dieser Zeit ist kein Anhydrid mehr vorhanden. Das Gemisch wird mit 185 g Epichlorhydrin versetzt und dann während 2 weiteren Stunden auf 90 °C erhitzt. Dabei fällt der Epoxidgehalt auf 0. Es werden weitere 925 g Epichlorhydrin zugegeben, und das Reaktionsgemisch wird unter vermindertem Druck unter Verwendung einer Dean-Stark-Apparatur bei 55–57 °C zum Rückfluss erhitzt. Schliesslich wird im Verlaufe von 2 Stunden eine Lösung von 88 g Natriumhydroxid in 88 g Wasser zugegeben, und es wird während weiteren $1^1/_2$ Stunden zum Rückfluss erhitzt. Während dieses Erhitzens bis zum Rückfluss fallen insgesamt 124 g Wasser an. Das Gemisch wird anschliessend gekühlt, filtriert, mit 200 ml 10%igem Natriumdihydrogenphosphat und schliesslich zweimal mit 500 ml Wasser gewaschen. Nach dem Trocknen über Megnesiumsulfat, das durch Filtrieren entfernt wird, wird überschüssiges Epichlorhydrin unter vermindertem Druck und Erhitzen auf 100 °C in einem Rotationsverdampfer entfernt. Das Endprodukt weist einen Epoxidgehalt von 3,36 Äquivalenten/kg (73% d.Th.) auf.

Harz 2

Harz 2 ist ein epoxidierter Novolak von 2,2-Bis (4-hydroxyphenyl)propan mit einem Erweichungspunkt von etwa 72 °C und einem Epoxidgehalt von 4,7 Äquiv./kg.

Harz 3

58,5 Teile 1,5-Bis(4-hydroxyphenyl)penta-1,4-dien-3-on, 51,6 Teile 1,3-Diglycidyl-5,5-pentamethylenhydantoin, 110,1 Teile 2-Hydroxyäthylmethacrylat und 0,3 Teile Tetramethylammoniumbromid werden zusammen während 9 Stunden auf 100 °C erhitzt. Es werden weitere 0,3 Teile Tetramethylammoniumbromid zugegeben, und die Temperatur wird weitere 6 Stunden gehalten. Danach beträgt der Epoxidgehalt 0,14 Äquiv./kg. Durch Zusatz von 2,5 Teilen Acrylsäure und Erhitzen während 1 1/2 Stunden auf 100 °C wird der Epoxidgehalt auf einen vernachlässigbaren Wert reduziert.

Harz 4

50 Teile Glycidylmethacrylat und 0,3 Teile Tetramethylammoniumchlorid werden auf 100 °C erhitzt. Dann gibt man 50 Teile 4-Hydroxyzimtsäure zu und rührt das Gemisch während 4 1/2 Stunden bei 100 °C. Dabei verringert sich der Epoxidgehalt auf 0,15 Äquiv./kg. Man gibt 15 Teile Hydroxyäthylmethacrylat zu und lässt das Gemisch auf Raumtemperatur abkühlen.

Harz 5

50 Teile Glycidylmethacrylat, 50 Teile 7-Hydroxycumarin und 0,3 Teile Tetramethylammoniumchlorid werden während 4 Stunden auf 100 °C erhitzt. Dabei verringert sich der Epoxidgehalt auf 0,2 Äquiv./kg. Anschliessend lässt man das Harz abkühlen.

Harz 6

Ein festes Epoxidharz, hergestellt aus 2,2-Bis(4-hydroxyphenyl)propan mit einem Epoxidgehalt von 1,5 Äquiv./kg und einem Erweichungspunkt von 73–79 °C, wird während 3 Stunden in Gegenwart von 5% Chromoctanoat und 0,2% 2,6-Di-tert-butyl-4-methylphenol mit 1 Äquivalent Acrylsäure (berechnet auf dem Epoxidgehalt) auf 120 °C erhitzt. Das Produkt weist einen vernachlässigbaren Epoxidgehalt (unter 0,2 Äquiv./kg) auf.

Harz 7

Harz 7 ist 2,2-Bis-[4-glycidyloxy-3-(1-propenyl)phenyl]-propan mit einem Epoxidgehalt von 4,19 Äquiv./kg.

Harz 8

Harz 8 ist 2,2-Bis[4-glycidyloxy-3-(2-propenyl)phenyl]propan mit einem Epoxidgehalt von 4,45 Äquiv./kg.

Harz 9

Ein Gemisch aus 100 g eines epoxidierten Novolaks, hergestellt aus einem Phenol-Formaldehyd-Novolak mit einem durchschnittlichen Molekulargewicht von 420 und einem Epoxidgehalt von 5,61 Äquiv./kg, 0,2 g 2,6-Di-tert-butyl-p-kresol und 0,1 g Chrom-(III)tris-octanoat wird auf 120 °C erhitzt und im Verlaufe einer Stunde mit 83 g Zimtsäure versetzt. Man erhitzt das Gemisch weitere 3 1/2 Stunden auf 120 °C und lässt es dann abkühlen. Das Produkt verfestigt sich bei Raumtemperatur und hat einen Epoxidgehalt von 0,16 Äquiv./kg.

Harz 10

60 g 2-Hydroxyäthylacrylat werden unter Rühren zu 59 g Phenylisocyanat und 0,2 Dibutylzinndilaurat zugetropft. Das Gemisch wird auf 70 °C erhitzt, bis alles Isocyanat umgesetzt ist.

Harz 11

Ein yemisch aus 9,9 g eines epoxidierten Novolaks, hergestellt aus einem Phenol-Formaldehyd-Novolak mit einem durchschnittlichen Molekulargewicht von 420 und einem Epoxidgehalt von 5,61 Äquiv./kg, 2,3 g 2,2-Bis(4-hydroxyphenyl-)-propan, 4,8 g 4-Azidobenzoesäure, 0,14 g 2,6-Di-tert-butyl-p-kresol, 0,05 g Tetramethylammoniumchlorid und 40 g Cyclohexanon werden unter Rühren während 5 Stunden auf 120 °C erhitzt. Anschliessend wird das Cyclohexanon mittels Destillation unter vermindertem Druck entfernt.

Harz 12

Harz 12 ist ein Diglycidyläther, hergestellt durch Vorverlängerung von 2,2-Bis(4-glycidyloxyphenyl)propan mit 2,2-Bis(3,5-dibrom-4-hydroxyphenyl)propan. Das Harz hat einen Erweichungspunkt von 50 °C und einen Epoxidgehalt von 2,0-2,2 Äquiv./kg.

Das Diphenyljodosyl-Hexafluorphosphat wird wie folgt hergestellt: Eine Lösung von 8 g Natriumhydroxid in 200 ml Wasser wird bei 0 °C mit 23,6 g Jodoxybenzol versetzt. Das Gemisch wird bei dieser Temperatur 1 1/2 Stunden gerührt, dann filtriert, und der Niederschlag wird entfernt. Dann gibt man eine 10%ige Lösung von Hexafluorphosphorsäure zu dem Filtrat, bis die Wasserstoffionen-Konzentration $1o^{-4}\,ml^{-1}$ erreicht. Während dieser Zeit bildet sich ein weisser Niederschlag. Dieser wird durch Filtration gesammelt, mit Wasser gewaschen und an der Luft getrocknet. Der weisse Feststoff wird mit Diäthyläther zerrieben, eingesammelt und erneut ge trocknet. Man erhält Diphenyljodosyl-Hexafluorphosphat in einer Ausbeute von 60%; Schmelzpunkt 128–130 °C.

Beispiel 1

94 Teile Harz 1, 3 Teile Cyclohexanonperoxid und 3 Teile Triphenylsulfonium-Hexafluorphosphat werden nach dem Schleuderverfahren auf ein kupferkaschiertes Laminat appliziert (Schichtdicke 6–8 µm) und während 6 Minuten auf 120 °C erhitzt. Die Schicht verfestigt sich und wird dann während 1 Minute durch ein Negativ mit einer 5000 W Metallhalogenidlampe in einem Abstand von 75 cm belichtet. Nach dem Entwickeln in Toluol, das 10% Aceton enthält, erhält man ein Bild, bei dem die nicht beschichteten Stellen der Schicht mit einer wässrigen Lösung von Eisen(III)chlorid (40% $FeCl_3$) bei 30 °C in 3 1/2 Minuten weggeätzt werden können, wobei die beschichteten Stellen intakt bleiben.

Beispiel 2

94 Teile Harz 1, 3 Teile Trigonox 51® (ein im Handel erhältliches Ketonperoxid-Gemisch der Fa. Akzo Chemie U.K. Ltd., Wandsworth, London S.W. 18) und 3 Teile Triphenylsulfonium-Hexafluorphosphat werden vermischt und nach dem Schleuderverfahren auf ein kupferkaschiertes Laminat appliziert (Schichtdicke 6–8 µm). Das beschichtete Laminat wird während 18 Minuten auf 120 °C erhitzt, wobei sich die Schicht verfestigt. Durch 1-minütige Bestrahlung durch ein Negativ mit einer 5000 W Metallhalogenidlampe in einem Abstand von 75 cm wird nach dem Entwickeln in Toluol, das 10% Aceton enthält, ein scharfes Bild erhalten.

Beispiel 3

94 Teile Harz 1, 3 Teile Cumolhydroperoxid und 3 Teile Triphenylsulfonium-Hexafluorphosphat werden durch Aufschleudern auf ein kupferkaschiertes Laminat appliziert (Schichtdicke 6–8 µm). Die erhaltene Beschichtung wird in einem Ofen während 10 Minuten auf 120 °C erhitzt. Das Harzgemisch verfestigt sich und wird dann während 1 Minute durch ein Negativ mit einer 5000 W Metallhalogenidlampe in einem Abstand von 75 cm belichtet. Nach dem Entwickeln in Toluol, das 10% Aceton enthält, erhält man ein Bild, das mit wässriger Eisen(III)chlorid-Lösung (40%) bei 30 °C in 200 Sekunden geätzt werden kann, wobei die beschichteten Stellen intakt bleiben.

Beispiel 4

Mit einem Gemisch aus 94 Teilen Harz 1, 3 Teilen Azobis-(isobutyronitril) und 3 Teilen Bis(p-tolyl)-jodonium-Hexafluorphosphat wird ein kupferkaschiertes Laminat nach dem Schleuderverfahren beschichtet (Schichtdicke 6–8 µm). Die Beschichtung wird in einem Ofen während 30 Minuten auf 120 °C erhitzt. Die Schicht verfestigt sich und wird anschliessend während 1½ Minuten durch ein Negativ mit einer 5000 W Metallhalogenidlampe in einem Abstand von 75 cm belichtet. Nach dem Entwickeln in Toluol, das 10% Aceton enthält, erhält man ein scharfes, glänzendes Bild.

Beispiel 5

70 Teile Harz 2, 30 Teile 1,4-Butandioldimethacrylat, 3 TeilenCumolhydroperoxid und 3 Teile Triphenylsulfonium-Hexafluorphosphat werden mittels eines Ziehgeräts Nr. 1 K auf ein kupferkaschiertes Laminat aufgetragen, wobei eine 6–8 µm dicke Beschichtungsteht. Diese Beschichtung wird in einem Ofen während 6 Minuten auf 120 °C erhitzt, wobei sie sich verfestigt. Die Beschichtung wird während 2 Minuten durch ein Negativ mit einer 5000 W Metallhalogenidlampe in einem Abstand von 75 cm belichtet.Durch Entwickeln in 1,1,1-Trichloräthan erhält man ein Bild.

Beispiel 6

Mit einem Gemisch aus 70 Teilen Harz 2, 30 Teilen 1,4-Butandioldimethacrylat, 3 Teilen Cyclohexanonperoxid und 3 Teilen Triphenylsulfonium-Hexafluorphosphat wird nach dem Schleuderverfahren ein kupferkaschiertes Laminat beschichtet; (Schichtdicke 6–8 µm) und während 5 Minuten auf 120 °C erhitzt. Die Schicht verfestigt sich und wird dann während 2 Minuten durch ein Negativ mit einer 5000 W Metallhalogenidlampe in einem Abstand von 75 cm belichtet. Durch Entwickeln in 1,1,1-Trichloräthan erhält man ein gutes Bild.

Beispiel 7

Mit einem Gemisch aus 70 Teilen Harz 2, 30 Teilen 1,4-Butandioldimethacrylat, 3 Teilen Cumolhydroperoxid und 3 Teilen Bis(p-tolyl)jodonium-Hexafluorphosphat wird nach dem Schleuderverfahren ein kupferkaschiertes Laminat beschichtet (Schichtdicke 6–8 µm) und während 7 Minuten auf 120 °C erhitzt. Die Beschichtung verfestigt sich und wird dann während 2 Minuten durch ein Negativ mit einer 5000 W Metallhalogenidlampe in einem Abstand von 75 cm belichtet. Nach dem Entwickeln der Beschichtung mit 1,1,1-Trichloräthan erhält man ein gutes Bild.

Beispiel 8

Es wird ein Gemisch gemäss Beispiel 7 verwendet, wobei jedoch das Cumolhydroperoxid durch Cyclohexanonperoxid ersetzt wird. Die Beschichtung auf dem kupferkaschierten Laminat wird während 5 Minuten auf 120 °C erhitzt und verfestigt sich. Nach dem Bestrahlen der Beschichtung während 2 Minuten durch ein Negativ mit einer 5000 W Metallhalogenidlampe in einem Abstand von 75 cm ethält man ein Bild, das mit 1,1,1-Trichloräthan entwickelt werden kann.

Beispiel 9

Mit einem Gemisch aus 67,5 Teilen 3'-Methacryloyloxy-2'-hydroxypropyl-anthracen-9-carboxylat, 27,5 Teilen Glycidylmethacrylat und 3 Teilen Cyclohexanonperoxid wird nach dem Schleuderverfahren ein kupferkaschiertes Laminat beschichtet (Schichtdicke 20 µm). Man erhitzt das Laminat während 10 Minuten auf 120 °C und lässt es dann abkühlen. Die verfestigte Schicht wird während 1½ Minuten durch ein Negativ mit einer 5000 W Metallhalogenidlampe in einem Abstand von 75 cm belichtet. Nach dem Entwickeln mit einem 1:1-Gemisch aus Cyclohexanon und 1,1,1-Trichloräthan erhält man ein gutes Bild.

Beispiel 10

Mit einem Gemisch aus 42 Teilen N-(2-Methacryloyloxy)-äthyl-2,3-dimethylmaleinimid, 42 Teilen 3-(Methacryloyloxy)-2-hydroxydibrom-p-kresyläther, 10 Teilen Glycidylmethacrylat und 5 Teilen Cumolhydroperoxid wird mittels Schleuderverfahren ein kupferkaschiertes Laminat beschichtet (Schichtdicke 6–8 µm) und während 20 Minuten auf 120 °C erhitzt. Die verfestigte Beschichtung wird anschliessend durch ein Negativ mit einer 5000 W Metallhalogenidlampe in einem Abstand von 75 cm belichtet. Nach dem Entwikkeln mit 1,1,1-Trichloräthan erhält man ein klares Bild.

Beispiel 11

Mit einem Gemisch aus 100 Teilen Harz 3 und 3 Teilen Cyclohexanonperoxid wird nach dem Schleuderverfahren ein kupferkaschiertes Laminat beschichtet und während 5 Minuten auf 120 °C erhitzt. Die verfestigte, etwa 20 µm dicke Schicht wird während 2 Minuten durch ein Negativ mit einer 5000 W Metallhalogenidlampe in einem Abstand von 75 cm belichtet. Durch Entwickeln mit einer 0,5%igen wässrigen Natriumhydroxidlösung erhält man ein Bild.

Beispiel 12

Mit einem Gemisch aus 65 Teilen Harz 4, 35 Teilen Glycidylmethacrylat und 3 Teilen Cyclohexanonperoxid wird nach dem Schleuderverfahren ein kupferkaschiertes Laminat beschichtet (Schichtdicke 12 µm). Die Harzschicht wird in einem Ofen durch 5 Minuten erhitzen auf 120 °C verfestigt. Anschliessend wird die Beschichtung während 1 1/2 Minuten durch ein Negativ mit einer 5000 W Metallhalogenidlampe in einem Abstand von 75 cm belichtet. Nach dem Entwickeln mit Toluol, das 2% Cyclohexanon enthält, erhält man ein glänzendes, scharfes Bild.

Beispiel 13

Mit einem Gemisch aus 75 Teilen Harz 5, 25 Teilen Glycidylmethacrylat und 3 Teilen Trigonox 51® wird nach dem Schleuderverfahren ein kupferkaschiertes Laminat beschichtet (Schichtdicke 12 µm). Die Beschichtung wird während 7 Minuten in einem Ofen auf 120 °C erhitzt und dadurch verfestigt. Das verfestigte Harz wird während 1 1/2 Minuten durch ein Negativ mit einer 5000 W Metallhalogenidlampe in einem Abstand von 75 cm belichtet. Nach dem Entwickeln mit Toluol, das 2% Cyclohexanon enthält, erhält man ein gut aufgelöstes glänzendes Bild.

Beispiel 14

Mit einem Gemisch aus 4,2 g Harz 6, 3,8 g Dipentaerythrit-Monohydroxyphentaacrylat, 2,1 g 1,4-Butandioldimethacrylat, 0,3 Benzildimethylketal und 0,3 g Cyclohexanonperoxid wird ein kupferkaschiertes Laminat beschichtet (Schichtdicke ca. 25 µm). Das beschichtete Laminat wird dann während 7 Minuten in einem Ofen auf 120 °C erhitzt, wobei man eine klebefreie Oberfläche erhält. Nach dem Bestrahlen der Beschichtung durch ein Negativ mit einer 5000 W Metallhalogenidlampe in einem Abstand von 75 cm und dem Entwickeln in Toluol erhält man ein scharfes, glänzendes Bild.

Beispiel 15

Mit einem Gemisch aus 20 Teilen Harz 7, 20 Teilen p-Bromstyrol, 3 Teilen Cyclohexanonperoxid und 3 Teilen Bis-(p-nitrophenyl)jodonium-Hexafluorphosphat wird ein kupferkaschiertes Laminat beschichtet (Schichtdicke 20 µm). Das Gemisch wird während 5 Minuten in einem Ofen auf 120 °C erhitzt und dadurch verfestigt. Nach dem Bestrahlen durch ein Negativ mit einer 5000 W Metallhalogenidlampe in einem Abstand von 75 cm erhält man ein Bild, das in Petroläther, der 5% Xylol enthält, entwickelt werden kann.

Beispiel 16

Mit einem Gemisch aus 100 Teilen Harz 8, 5 Teilen Cyclohexanonperoxid und 5 Teilen Bis(p-tolyl)jodonium-Hexafluorphosphat wird ein kupferkaschiertes Laminat beschichtet (Schichtdicke 15 µm). Die Schicht wird während 25 Minuten in einem Ofen auf 120 °C erhitzt und dadurch verfestigt. Nach dem Bestrahlen des Films während 1 1/2 Minuten durch ein Negativ mit einer 5000 W Metallhalogenidlampe in einem Abstand von 75 cm und dem Entwickeln in Toluol erhält man ein Bild.

Beispiel 17

Mit einem Gemisch aus 10 Teilen Harz 9, 5 Teilen Diäthylaminoäthylacrylat, 0,6 Teilen Cumolhydroperoxid, 0,2 Teilen Michler's Keton und 0,5 Teilen Benzoesäuresulfimid wird ein kupferkaschiertes Laminat beschichtet (Schichtdicke 12 µm). Die Beschichtung wird während 1 Minute in einem Ofen auf 120 °C erhitzt und dadurch verfestigt. Nach dem Bestrahlen der verfestigten Beschichtung während 2 Minuten durch ein Negativ mit einer 5000 W Metallhalogenidlampe in einem Abstand von 75 cm und dem Entwickeln in Äthanol erhält man ein Bild.

Beispiel 18

Mit einem Gemisch aus 60 Teilen Harz 9, 40 Teilen Harz 10 und 3 Teilen Cyclohexanonperoxid wird ein kupferkaschiertes Laminat beschichtet (Schichtdicke 10 µm). Die Beschichtung wird während 10 Minuten in einem Ofen auf 120 °C erhitzt, wobei sie sich verfestigt. Durch Bestrahlen der verfestigten Beschichtung während 2 Minuten durch ein Negativ mit einer 5000 W Metallhalogenidlampe in einem Abstand von 75 cm und Entwickeln in Äthanol, das 5% Aceton enthält, erhält man ein Bild.

Beispiel 19

Mit einem Gemisch aus 80 Teilen Harz 11, 20 Teilen 2-Cyanäthylacrylat, 5 Teilen Cumolhydroperoxid und 0,1 Teilen Eisennaphthenat wird ein kupferkaschiertes Laminat beschichtet (Schichtdicke 12 µm). Die Beschichtung wird verfestigt, indem man sie während 3 Minuten in einem Ofen auf 100 °C erhitzt. Nach dem Bestrahlen der verfestigten Schicht während 2 Minuten durch ein Negativ mit einer 5000 W Metallhalogenidlampe in einem Abstand von 75 cm und dem Entwickeln in Toluol erhält man ein gutes klares Bild.

Beispiel 20

Mit einem Gemisch aus 64 Teilen Harz 12, 36 Teilen Diglycidyl-1,2-cyclohex-4-endicarboxylat, 3 Teilen Cyclohexanonperoxid und 3 Teilen Triphenylsulfonium-Hexafluorphosphat wird ein kupferkaschiertes Laminat beschichtet (Schicht-

dicke 15–18 µm). Dann erhitzt man das beschichtete Laminat während 10 Minuten in einem Ofen auf 120 °C und lässt es abkühlen. Dabei erhält man eine klebefreie Oberfläche. Die Beschichtung wird während 3 Minuten durch ein Negativ mit einer 5000 W Metallhalogenidlampe in einem Abstand von 75 cm belichtet und dann in Toluol entwickelt. Man erhält ein scharfes, hartes Bild.

Beispiel 21

Mit einem Gemisch aus 6,6 Teilen Harz 12, 1,6 Teilen Diallylphthalat, 1,6 Teilen p-Bromstyrol, 0,3 Teilen Cyclohexanonperoxid und 0,3 Teilen Triphenylsulfonium-Hexafluorphosphat wird ein kupferkaschiertes Laminat beschichtet (Schichtdicke 6–8 µm). Die Beschichtung wird verfestigt, indem man sie in einem Ofen während 5 Minuten auf 120 °C erhitzt. Man bestrahlt die verfestigte Beschichtung während 2½ Minuten durch ein Negativ mit einer 5000 W Metallhalogenidlampe in einem Abstand von 75 cm und entwickelt in Toluol zu einem Bild.

Beispiel 22

Mit einem Gemisch aus 100 Teilen Harz 1, 3 Teilen Azobis(isobutyronitril) und 3 Teilen Diphenyljodosyl-Hexafluorphosphat wird ein kupferkaschiertes Laminat beschichtet (Schichtdicke 6–8 µm). Die Beschichtung wird verfestigt, indem man sie während 30 Minuten in einem Ofen auf 120 °C erhitzt. Die verfestigte Beschichtung dann während 1 Minute durch ein Negativ mit einer 5000 W Metallhalogenidlampe in einem Abstand von75 cm belichtet. Nach dem Entwickeln in Toluol, das 15% Aceton enthält, erhält man ein gutes, hartes und scharfes Bild. Die nicht beschichteten Stellen können mit einer wässrigen Eisen(III)chlorid-Lösung (40% $FeCl_3$) bei 30 °C in 200 Sekunden weggeätzt werden, wobei die beschichteten Stellen unverändert bleiben.

Beispiel 23

Mit einem Gemisch aus 70 Teilen Harz 2, 30 Teilen 1,4-Butandioldimethacrylat und 3 Teilen Diphenyljodosyl-Hexafluorphosphat wird ein kupferkaschiertes Laminat beschichtet (Schichtdicke 6–8 µm). Die Schicht wird 5 Minuten auf 120 °C erhitzt, wobei sie sich verfestigt. Die verfestigte Schicht wird während 2 Minuten durch ein Negativ mit einer 5000 W Metallhalogenidlampe in einem Abstand von 75 cm belichtet. Nach dem Entwickeln in 1,1,1-Trichloräthan erhält man ein gutes scharfes Bild

**Patentansprüche**

1. Verfahren zur Bilderzeugung, dadurch gekennzeichnet, dass man

(i) eine auf einem Trägermaterial applizierte Schicht aus einem flüssigen Stoffgemisch, das

(A) eine Verbindung mit mindestens einer hitze-polymerisierbaren äthylenisch ungesättigten Gruppe,

(B) ein photopolymerisierbares Material und

(C) einen hitze-aktivierbaren freien Radikal-Initiator für die Polymerisation von (A) enthält, auf Temperaturen erhitzt, bei denen der Initiator (C) aktiviert wird, wobei das Material (A) über seine hitze-polymerisierbaren äthylenisch ungesättigten Gruppen polymerisiert wird und sich die Schicht verfestigt, aber photopolymerisierbar bleibt,

(ii) die verfestigte Schicht in einem vorgegebenen Muster mit aktinischem Licht derart bestrahlt, dass die belichteten Stellen der Schicht photopolymerisiert werden, und

(iii) die im wesentlichen nicht photopolymerisierten Stellen der Schicht durch Behandlung mit einem dafür geeigneten Lösungsmittel entfernt.

2. Verfahren nach Anspruch 1, worin das flüssige Stoffgemisch ein Gemisch aus einer oder mehreren hitze-polymerisierbaren Substanzen (A) und einer oder mehreren Substanzen (B) enthält, welche ausschliesslich photopolymerisierbar sind.

3. Verfahren nach Anspruch 1, worin das flüssige Stoffgemisch aus (A) und (B) eine oder mehrere doppelfunktionelle Substanzen mit einer oder mehreren hitze-polymerisierbaren äthylenisch ungesättigten Gruppen und einer oder mehreren photopolymerisierbaren Gruppen, gegebenenfalls zusammen mit einer oder mehreren hitzepolymerisierbaren Substanzen und/oder einer oder mehreren ausschliesslich photopolymerisierbaren Substanzen, enthält.

4. Verfahren nach einem der Ansprüche 1–3, worin die hitze-polymerisierbare Substanz (A) ein Styrol, eine allylische Verbindung, ein Cyclohexen oder ein Acrylsäureester ist.

5. Verfahren nach Anspruch 4, worin die hitzepolymerisierbare Substanz (A)

a) ein Styrol der Formel I

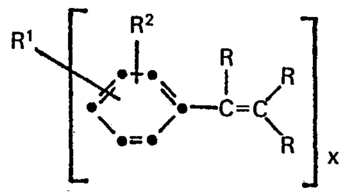

(I),

worin die R unabhängig voneinander ein Wasserstoffatom oder eine Alkylgruppe mit 1–4 C-Atomen bedeuten,

x 1 oder 2 ist und

$R^1$ bei x = 1, ein Wasserstoffatom oder eine Alkylgruppe mit 1–4 C-Atomen, bei x = 2, eine Alkylengruppe mit 1–4 C-Atomen, ein Sauerstoff- oder Schwefelatom, eine Carbonyl- oder Sulfonylgruppe und

$R^2$ ein Wasserstoff- oder Halogenatom, eine Alkylgruppe mit 1–4 C-Atomen, eine Hydroxylgruppe, eine Glycidyloxygruppe oder den Rest einer Glycidyloxygruppe nach der Umsetzung mit einem Phenol oder einer Carbonsäure bedeuten,

b) eine allylische Verbindung der Formel IIA oder IIB

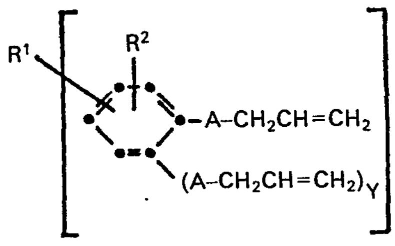

(IIA)

oder

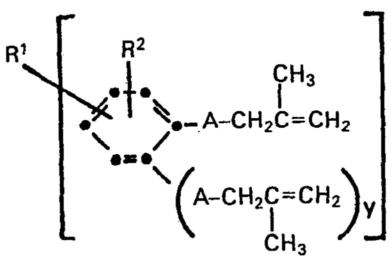

(IIB)

worin $R^1$, $R^2$ und x die unter Formel I angegebene Bedeutung haben, y Null oder 1 ist und A eine kovalente Bindung, ein Sauerstoffatom oder eine Carbonyloxygruppe bedeutet,

c) ein Cyclohexen der Formel IIIA oder IIIB

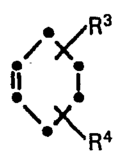

oder

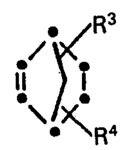

(IIIA) (IIIB)

worin $R^3$ und $R^4$ unabhängig voneinander ein Wasserstoff- oder Halogenatom, eine Alkylgruppe mit 1–6 C-Atomen, eine Carboxylgruppe oder eine gegebenenfalls eine Epoxidgruppe enthaltende Estergruppe mit 3–10 C-Atomen darstellt, oder

d) ein Acrylsäureester mit mindestens einer Gruppe der Formel IV

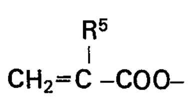

(IV),

ist, worin $R^5$ ein Wasserstoff-, Chlor- oder Bromatom oder eine Alkylgruppe mit 1–4 C-Atomen darstellt.

6. Verfahren nach Anspruch 1, worin das photopolymerisierbare Material (B) ein solches ist, bei dem die Polymerisation durch direkte Aktivierung lichtempfindlicher Gruppen mittels Bestrahlung erfolgt.

7. Verfahren nach Anspruch 6, worin das photopolymerisierbare Material (B) mindestens zwei Gruppen ausgewählt aus Azido-, Cumarin-, Stilben-, Maleimid-, Pyridinon-, Chalkon-, Propenon-, Pentadienon-, Anthracen- oder Acrylsäureestergruppen aufweist, wobei die letzteren in 3-Stellung durch eine äthylenisch ungesättigte Gruppe oder eine Gruppe aromatischen Charakters in Konjugation mit der äthylenischen Doppelbindung der Acrylsäureestergruppe substituiert sind.

8. Verfahren nach einem der Ansprüche 1–5, worin das photopolymerisierbare Material (B) ein solches ist, bei welchem die Bestrahlung ein geeignetes Initiatormolekül aktiviert, das seinerseits polymerisierbare Gruppen aktiviert.

9. Verfahren nach Anspruch 8, worin das photopolymerisierbare Material (B) ein Epoxidharz, ein phenolisches Harz, ein Harnstoff-Formaldehydharz, ein cyclischer Äther, ein cyclisches Ester, ein cyclisches Sulfid, ein cyclisches Amin oder eine cyclische Organosilikonverbindung ist, in Kombination mit einem strahlungsempfindlichen aromatischen Onium- oder Jodosyl-Salz.

10. Verfahren nach einem der Ansprüche 1 und 3 bis 9, worin (a) das flüssige Stoffgemisch eine doppelfunktionelle Substanz mit einer oder mehreren Acrylsäureestergruppen und einer oder mehreren lichtempfindlichen Gruppen, ausgewählt aus Azido-, Cumarin-, Maleinimid-, Chalkon-, Propenon-, Pentadienon-, Anthracen- oder Acrylsäureestergruppen, enthält, wobei die letzteren in 3-Stellung durch eine äthylenisch ungesättigte Gruppe oder eine Gruppe aromatischen Charakters in Konjugation mit der äthylenischen Doppelbindung der Acrylsäureestergruppe substituiert sind, oder (b) das flüssige Stoffgemisch eine doppelfunktionelle Substanz mit einer Epoxidgruppe und einer Acrylsäureestergruppe zusammen mit einem strahlungsempfindlichen aromatischen Onium- oder Jodosyl-Salz enthält.

11. Verfahren nach einem der vorhergehenden Ansprüche, worin der hitzeaktivierbare freie Radikalinitiator (C) ein organisches Peroxid oder Hydroperoxid, eine Azoverbindung, ein sterisch gehindertes phenyl-substituiertes Alkan, oder ein aromatisches Jodosyl-Salz ist.

12. Verfahren nach einem der vorhergehenden Ansprüche, worin die erste Verfahrensstufe durch Erhitzen des Stoffgemisches auf eine Temperatur zwischen 80 und 150 °C durchgeführt wird.

## Revendications

1. Procédé pour créer des images, procédé caractérisé en ce que:

(i) on chauffe und couche qui a été appliquée sur une matière support à partir d'un mélange liquide contenant:

(A) un composé renfermant au moins un radical éthylénique thermopolymérisable,

(B) une matière photopolymérisable et

(C) un amorceur radicalaire thermo-activable pour la polymérisation de (A) à des températures auxquelles l'amorceur (C) est activé, traitement au cours duquel la matière (A) se polymérise par ses radicaux éthyléniques thermopolymérisables et la couche se solidifie mais tout en restant photopolymérisable,

(ii) on irradie la couche solidifiée, conformément à un modèle donné, au moyen d'un rayonnement actinique de telle façon que les endroits de la couche qui ont été touchés par le rayonnement soient photopolymérisés, et

(iii) on élimine les endroits de la couche qui n'ont pratiquement pas été photopolymérisés en traitant celle-ci par un solvant approprié.

2. Procédé selon la revendication 1 caractérisé en ce que le mélange liquide contient un mélange d'une ou de plusieurs substances thermopolymérisables (A) et d'une ou de plusieurs substances exclusivement photopolymérisables (B).

3. Procédé selon la revendication 1 caractérisé en ce que le mélange liquide de (A) et (B) contient une ou plusieurs substances «à double fonction» comportant un ou plusierus radicaux éthyléniques thermopolymérisables et un ou plusieurs radicaux photopolymérisables, éventuellement associées à une ou plusieurs substances thermopolymérisables et/ou à une ou plusieurs substances exclusivement photopolymérisables.

4. Procédé selon l'une quelconque des revendications 1 à 3, caractérisé en ce que la substance thermopolymérisable (A) est un styrène, un composé allylique, un cyclohexène ou un ester acrylique.

5. Procédé selon la revendication 4 caractérisé en ce que la substance thermopolymérisable (A) est:

a) un styrène répondant à la formule I:

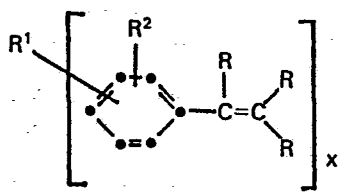
(I),

dans laquelle: les

R représentent chacun, indépendamment l'un de l'autre, un atome d'hydrogène ou un alkyle contenant de 1 à 4 atomes de carbone,

x est égal à 1 ou à 2,

$R^1$ représente, dans le cas où x est égal à 1, un atome d'hydrogène ou un alkyle en $C_1$–$C_4$ et, dans le cas où x est égal à 2, un alkylène en $C_1$–$C_4$, un atome d'oxygène ou de soufre, un carbonyle ou un sulfonyle et

$R^2$ représente un atome d'hydrogène ou d'halogène, un alkyle en $C_1$–$C_4$, un hydroxy, un glycidyloxy ou le radical résultant de la réaction d'un radical glycidyloxy avec un phénol ou un acide carboxylique,

b) un composé allylique répondant à l'une des formules IIA et IIB:

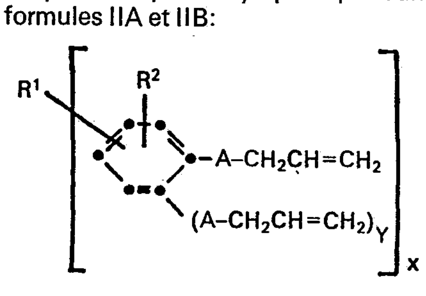
(IIA)

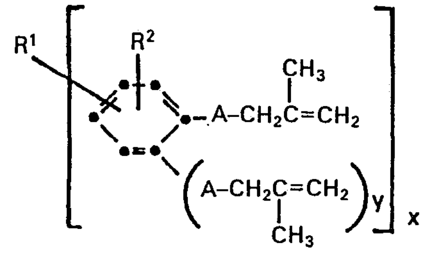
(IIB)

dans lesquelles $R^1$, $R^2$ et x ont les significations données ci-dessus à propos de la formule I, y est égal à 0 ou à 1 et A représente une liaison covalente, un atome d'oxygène ou un radical carbonyloxy,

c) un cyclohexène répondant à l'une des formules IIIA et IIIB:

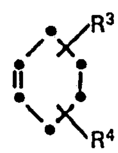
oder
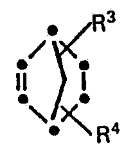

(IIIA) (IIIB)

dans lesquelles $R^3$ et $R^4$ représentent chacun, indépendamment l'un de l'autre, un atome d'hydrogène ou d'halogène, un alkyle en $C_1$–$C_6$, un carboxy ou un radical d'ester en $C_3$–$C_{10}$ qui contient éventuellement un radical époxy, ou

d) un ester acrylique contenant au moins un radical répondant à la formule IV:

$$CH_2=\overset{R^5}{\overset{|}{C}}-COO- \qquad (IV),$$

dans laquelle $R^5$ représente un atome d'hydrogène, de chlore ou de brome ou un radical alkyle contenant de 1 à 4 atomes de carbone.

6. Procédé selon la revendication 1 caractérisé en ce que la matière photopolymérisable (B) est une matière de ce type dont la polymérisation est produite par activation directe de radicaux photosensibles au moyen d'un rayonnement.

7. Procédé selon la revendication 6 caractérisé en ce que la matière photopolymérisable (B) contient au moins 2 radicaux pris dans l'ensemble constitué par des radicaux d'azides, de coumarines, de stilbènes, de maléimides, de pyridiones, de chalcones, de propénones, de pentadiénones, d'anthracènes ou d'esters acryliques, les derniers cités portant en position 3 un radical éthylénique ou un radical de caractère aromatique en conjugaison avec la double liaison éthylénique du radical d'ester acrylique.

8. Procédé selon l'une quelconque des revendications 1 à 5, caractérisé en ce que la matière photopolymérisable (B) est une matière de ce type dans laquelle l'irradiation active une molécule

amorceuse appropriée, laquelle active à son tour des radicaux polymérisables.

9. Procédé selon la revendication 8 caractérisé en ce que la matière photopolymérisable (B) est une résine époxydique, une résine phénolique, une résine urée-formaldéhyde, un éther cyclique, un ester cyclique, un sulfure cyclique, une amine cyclique ou un composé organosilicique cyclique, en association avec un sel d'onium ou d'iodosyle aromatique sensible aux rayonnements.

10. Procédé selon l'une quelconque des revendications 1 et 3 à 9, caractérisé en ce que (a) le mélange liquide contient une substance «à double fonction» comportant un ou plusieurs radicaux d'esters acryliques et un ou plusieurs radicaux photosensibles pris dans l'ensemble constitué par les radicaux d'azides, de coumarines, de maléimides, de chalcones, de propénones, de pentadiénones, d'anthracènes et d'esters acryliques, ces derniers portant, en position 3, un radical éthylénique ou de caractère aromatique conjugué par rapport à la double liaison éthylénique du radical d'ester acrylique, ou (b) le mélange liquide contient une substance «à double fonction» comportant un radical époxy et un radical d'ester acrylique, ainsi qu'un sel d'onium ou d'iodosyle aromatique photosensible.

11. Procédé selon l'une quelconque des revendications précédentes, procédé caractérisé en ce que l'amorceur à radicaux libres thermo-activable (C) est un hydroperoxyde ou un peroxyde organique, un composé azoïque, un alcane phénylé à empêchement stérique, ou un sel d'iodosyle aromatique.

12. Procédé selon l'une quelconque des revendications précédentes, caractérisé en ce que, au cours de la première étape opératoire, on chauffe le mélange à une température comprise entre 80 et 150 °C.

**Claims**

1. A process for the production of an image comprising

(i) heating a layer, supported on a carrier, of a liquid composition containing

(A) a compound containing at least one heat-polymerizable, ethylenically unsaturated group,

(B) a photopolymerizable material, and

(C) a thermally activated free radical initiator for polymerization of (A) to a temperature at which the initiator (C) is activated, thereby polymerizing the compound (A) through the heat-polymerizable ethylenically unsaturated group or groups thereof such that the layer solidifies but remains photopolymerizable, and subsequently

(ii) exposing the solidified layer to actinic radiation in a predetermined pattern such that exposed parts of the layer are photopolymerized and

(iii) removing those parts of the layer which have not become substantially photopolymerized by treatment with a solvent therefor.

2. A process according to claim 1, wherein the liquid composition comprises a mixture of one or more heat-polymerizable substances (A) with one or more substances (B) which are exclusively photopolymerizable.

3. A process according to claim 1, wherein the liquid composition comprises one or more dual-functional substances having one or more heat-polymerizable ethylenically unsaturated groups and one or more photopolymerizable groups which is present as both (A) and (B), optionally together with one or more heat-polymerizable substances and/or one or more exclusively photopolymerizable substances.

4. A process according to any one of claims 1 to 3, wherein the heat-polymerizable compound (A) is a styrene, an allylic compound, a cyclohexene or an acrylic ester.

5. A process according to claim 4, wherein the heat-polymerizable compound (A) is

a) a styrene of formula

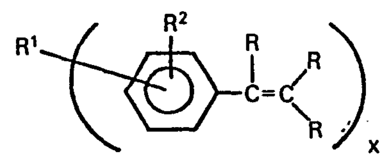

(I),

where each group R is independently a hydrogen atom or an alkyl group of 1 to 4 carbon atoms,

x is 1 or 2, and

when x is 1, $R^1$ is a hydrogen atom or an alkyl group of 1 to 4 carbon atoms,

when x is 2, $R^1$ is an alkylene group of 1 to 4 carbon atoms, an oxygen or sulfur atom, or a carbonyl or sulfonyl group, and

$R^2$ is a hydrogen or halogen atom, an alkyl group of 1 to 6 carbon atoms, a hydroxy group or a glycidyloxy group or the residue of a glycidyloxy group that has been reacted with a phenol or a carboxylic acid,

b) an allylic compound of formula

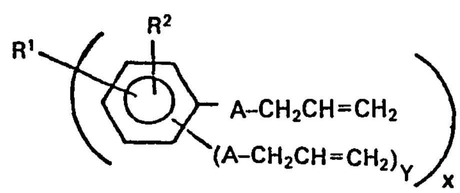

(IIA)

or

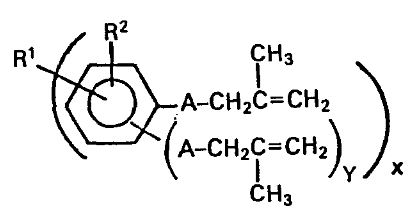

(IIB)

wherein $R^1$, $R^2$ and x are as defined for formula I,

y is 0 or 1, and

A is a covalent bond, an oxygen atom, or a carbonyloxy group,

c) a cyclohexene of formula

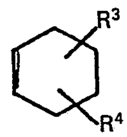

or

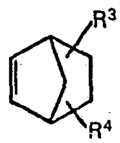

where $R^3$ and $R^4$ are each independently of the other a hydrogen atom, a halogen atom, an alkyl group of 1 to 6 carbon atoms, a carboxyl group or an ester group of 3 to 10 carbon atoms, optionally containing an epoxide group, or

d) an acrylic ester containing at least one group of formula

$$CH_2{=}\overset{R^5}{\overset{|}{C}}-COO- \qquad (IV)$$

wherein $R^5$ is a hydrogen, chlorine, or bromine atom or an alkyl group of 1 to 4 carbon atoms.

6. A process according to claim 1, wherein the photopolymerizable material (B) is one in which polymerization is effected by direct activation of photosensitive groups through irradiation.

7. A process according to claim 6, in which the photopolymerizable material (B) contains at least two groups selected from azido, coumarin, stilbene, maleimido, pyridionone, chalcone, propenone, pentadienone, or anthracene groups, or acrylic ester groups which are substituted in their 3-position by a group having ethylenic unsaturation or aromaticity in conjugation with an ethylenic double bond of the acrylic group.

8. A process according to any one of claims 1 to 5, wherein the photopolymerizable material (B) is one in which irradiation activates a suitable initiator molecule which then activates polymerizable groups.

9. A process according to claim 8, wherein the photopolymerizable material (B) is an epoxide resin, phenolic resin, urea-formaldehyde resin, cyclic ether, cyclic ester, cyclic sulfide, cyclic amine or organosilicon cyclic in combination with a radiationsensitive aromatic onium or iodosyl salt.

10. A process according to any one of claims 1 or 3 to 9, wherein (a) the liquid composition contains a dualfunctional material having one or more acrylic ester groups and one or more photosensitive groups selected form azido, coumarin, maleimido, chalcone, propenone, pentadienone or anthracene groups, or acrylic ester groups substituted in their 3-position by a group having ethylenic unsaturation or aromaticity in conjugation with an ethylenic double bond of the acrylic ester group, or (b) the liquid composition contains a dual-functional material having both an epoxide group and an acrylic ester group, together with a radiation-sensitive aromatic onium or iodosyl salt.

11. A process according to any one of the preceding claims, wherein the thermally-activated, free radical initiator (C) is an organic peroxide or hydroperoxide, an azo compound, a sterically hindered phenyl-substituted alkane, or an aromatic iodosyl salt.

12. A process according to any one of the preceding claims, wherein the first stage is carried out by heating the composition to a temperature in the range from 80° to 150 °C.